# EUROPÄISCHE PATENTSCHRIFT

(11) **EP 4 275 060 B1**
(45) Veröffentlichungstag und Bekanntmachung des Hinweises auf die Patenterteilung: **25.09.2024**
(21) Anmeldenummer: 21708126.4
(22) Anmeldetag: 09.02.2021
(51) Int. Cl.: G01R 19/25

(54) **SENSOREINHEIT UND VERFAHREN ZUM ERKENNEN VON FEHLERSTRÖMEN IN EINEM ENERGIEVERSORGUNGSNETZ**
SENSOR UNIT AND METHOD FOR IDENTIFYING FAULT CURRENTS IN A POWER SUPPLY NETWORK
UNITÉ DE DÉTECTION ET PROCÉDÉ D'IDENTIFICATION DE COURANTS DE DÉFAUT DANS UN RÉSEAU D'ALIMENTATION ÉLECTRIQUE

(43) Veröffentlichungstag der Anmeldung: 15.11.2023
(73) Patentinhaber: Siemens Aktiengesellschaft, 80333 München (DE)
(72) Erfinder: HAUER, Daniel, 3400 Klosterneuburg (AT); EINFALT, Alfred, 1210 Wien (AT); KRAMMER, Lukas, 1220 Wien (AT)
(74) Vertreter: Siemens Patent Attorneys
(86) Internationale Anmeldenummer: PCT/EP2021/053034
(87) Internationale Veröffentlichungsnummer: WO 2022/171269

(56) Entgegenhaltungen:
- DE-A1- 102018 106 940
- DE-B4- 112010 001 638
- US-A1- 2004 183 522
- US-A1- 2012 249 151
- US-A1- 2013 321 965

## Beschreibung

### Technisches Gebiet

Die vorliegende Erfindung betrifft allgemein das Gebiet der Energieverteilungsnetze und der Energieversorgung. Im Speziellen bezieht sich die vorliegende Erfindung auf eine Sensoreinheit, welche ein Erkennen von Fehlerströmen bzw. Störungen in einem zu überwachenden Leiter in einem Energieversorgungsnetz ermöglicht. Dabei weist die Sensoreinheit einen Stromwandler auf, welcher in einer Messphase zum Ermitteln eines Stroms im zu überwachenden Leiter des Energieversorgungsnetzes über einen Lastwiderstand und in der Ladephase zum Aufladen eines Energiebuffers zur internen Energieversorgung der Sensoreinheit eingesetzt wird. Zur Ansteuerung der Sensoreinheit sowie zum Auswerten und Übertragen von Messergebnissen ist eine elektronische Einheit vorgesehen. Weiterhin bezieht sich die vorliegende Erfindung auf ein Verfahren zum lückenlosen Erkennen von Fehlerströmen in einem Energieversorgungsnetz unter Verwendung der erfindungsgemäßen Sensoreinheit.

### Stand der Technik

Durch eine zunehmende Durchdringung mit dezentralen, meist erneuerbaren Energieerzeugungsanlagen (z.B. Photovoltaikanlagen, Windkraftanlagen, etc.) ist der klassische Betrieb von Energieversorgungsnetzen, wie z.B. Mittelspannungs- und Niederspannungsnetze, vor große Herausforderungen gestellt. Zusätzlich führen die Entwicklung der Elektromobilität und damit eine verstärkte Substitution von anderen Energieübertragungsformen durch Elektrizität zu weiteren Herausforderungen. Als Lösung werden häufig so genannte Intelligente Stromnetze (Smart Grids) gesehen.

Elektrische Energieversorgungsnetze dienen der Übertragung und Verteilung elektrischer Energie vom Erzeuger bis hin zum Endverbraucher. Dabei ist es eine wichtige Aufgabe eines Betreibers eines Energieversorgungsnetzes, für die Sicherung und Verbesserung der Zuverlässigkeit der Versorgung der Endverbraucher mit elektrischer Energie zu sorgen. Ein weiterer, wichtiger Aspekt in der Betriebsführung moderner Energieverteilungs- und -versorgungsnetzen ist neben einer optimalen Betriebsführung im Normalbetrieb auch eine Digitalisierung und Automatisierung eines Störungsmanagements, um beispielsweise Fehlfunktionen und Störungen (z.B. Beschädigung, Kurzschluss, Erdschluss, etc.) in der Infrastruktur des Energieversorgungsnetzes (z.B. Trafostationen, Leitungen, Kabel, etc.) rasch und zielgerichtet erkennen, lokalisieren und beheben zu können. Dadurch wird die Sicherheit von Personen und eine Schonung von Betriebsmitteln sichergestellt. Weiterhin kann die Anzahl der vom Fehlerfall betroffenen Endverbrauchern bzw. Kunden möglichst niedrig gehalten werden.

Häufig können in Übertragungsnetzen der Hochspannungsebene (z.B. in Europa in einem Spannungsbereich von 60kV (Kilovolt) bis 380kV und höher) sowie in Verteilnetzen der Mittelspannungsebenen (z.B. 1 kV bis ca. 60 kV in Europa), meist der höheren Mittelspannungsebene, Fehler vergleichsweise rasch erkannt und lokalisiert werden, da üblicherweise in diesen Netzen mit vergleichsweise hoher Abdeckung relativ teure Schutz-, Mess- und Stationsleitgeräte für eine Netzautomatisierung zum Einsatz kommen. So sind insbesondere die Verteilnetze auf der meist niedrigen Mittelspannungsebene und vor allem die Verteilnetze auf Niederspannungsebene (z.B. zwischen 230/400 Volt bis zu 1000 Volt in Mitteleuropa) vergleichsweise wenig automatisiert. Vor allem ein Betriebszustand von Niederspannungsnetzen ist für den jeweiligen Netzbetreiber oft nur schwer zu ermitteln. Allerdings ist eine rasche und zielgerichtete Fehlerlokalisierung essenziell für einen effizienten Netzbetrieb. Weiterhin werden Leitungen von Energieversorgungsnetzen - unabhängig von der Spannungsebene - kaum überwacht. So kommen beispielsweise im Fall von Übertragungsnetzen sehr lange unüberwachte Leitungsstränge zwischen Verteil- und Schalteinheiten vor. Tritt beispielsweise ein Fehler entlang einer solchen Leitung auf, so ist es relativ schwierig die Fehlerstelle zu identifizieren und zielgerichtet eine Behebung zu initiieren.

Häufig erhielt ein Betreiber eines Energieversorgungsnetzes, insbesondere auf Niederspannungsebene, Meldungen über Fehlerfälle (z.B. Stromausfälle) beispielsweise direkt von seinen Kunden bzw. von den Endverbrauchern, welche z.B. einen Ausfall der Energieversorgung telefonisch dem Betreiber gemeldet haben. Derartige Meldungen mussten gesammelt, geprüft und entsprechend bearbeitet werden. Ein derartiges Vorgehen allein war nicht selten mit einem vergleichsweisen hohen Zeitaufwand verbunden.

Mittlerweile wurde beispielsweise dazu übergegangen, elektrische Verteilnetze, insbesondere Energieversorgungsnetz auf der niedrigen Mittelspannungsebene und der Niederspannungsebene, mit Sensoreinheiten auszustatten, welche zumindest eine Beobachtung des Betriebszustands der Energieversorgungsnetzes ermöglichen. Derartige Sensoreinheiten sind z.B. so genannte Fehlerindikatoren (auch als "Fault Circuit Indicator" (FCI) oder "Fault Passage Indicator (FPI) bezeichnet), welche z.B. eine Strommessung an ihrer Einbaustelle (z.B. bei einer Freileitung und/oder einer Kabelleitung des Energieversorgungsnetzes) vornehmen. Anhand eines gemessenen Stroms können derartige Sensoreinheiten auf einen zulässigen oder einen unzulässigen Betriebszustand bzw. auf einen Fehlerfall (z.B. Beschädigung der Freileitung bzw. der Kabelleitung, bei Kurz- oder Erdschluss, etc.) im Energieversorgungsnetz schließen. Wird von einer derartigen Sensoreinheit ein Fehlerfall an ihrer Messstelle erkannt, so kann die Sensoreinheit ein Signal oder eine Meldung abgeben, durch welche ein Fehlerfall erkannt und lokalisiert werden kann.

Derartige so genannte Fehlerindikatoren sind in unterschiedlichen Ausführungen bereits am Markt verfügbar. Frühere Fehlerindikatoren, wie z.B. ein aus der Schrift US 5,677,678 bekannter Fehlerindikator, waren lediglich in der Lage einen Fehlerzustand an der Messstelle mittels eines optischen Signals anzuzeigen. Diese ausschließlich optische Anzeige bedeutet für die Wartung, dass diejenigen Leitung abgesucht werden muss, an welcher der Fehler erwartet wird, bis die Fehlerstelle gefunden wird.

Daher wurde dazu übergegangen, die Sensoreinheiten bzw. Fehlerindikatoren mit Kommunikationsfähigkeit auszustatten und diese beispielsweise als zusätzliche Komponenten in ein Netzleitsystem des Betreibers des Energieversorgungsnetzes einzubinden. Derartige Konzepte sind z.B. aus den Schriften US 8,665,102 B2 oder WO 2016/023585A1 bekannt. Derartige Sensoreinheiten weisen z.B. eine Funkanbindung auf, über welche von den Sensoreinheiten Messwerte und/oder Fehler-/Störungsmeldungen an eine übergeordnete Kontrolleinheit, welche z.B. in einer Trafostation an einem Übergang zur nächst höheren Spannungsebene oder in einer Leitwarte angebracht ist, bzw. an ein Überwachungssystem gesendet werden können. Für die Funkanbindung können die Sensoreinheiten bzw. Fehlerindikatoren beispielsweise werkseitig mit einem Funkmodul (z.B. Modem, Mobilfunk-Gateway, Transceiver, etc.) ausgestattet sein. Häufig werden in derartigen Sensoreinheiten interne Energiespeicher, wie z.B. Batterien, Akkus etc., genutzt, um die Sensoreinheit unabhängig mit Energie zu versorgen. Derartige Sensoreinheiten müssen jedoch in regelmäßigen Abständen gewartet werden, da z.B. Batterien oder Akkus eine begrenzte Lebensdauer aufweisen.

Aus der Schrift US 2020/0408810 A1 ist beispielsweise ein Stromsensor zur Ermittlung einer Höhe eines elektrischen Stroms in einem Leiter eines Energieversorgungsnetzes bekannt, welcher einen Stromwandler sowohl zur Messung des Stroms im Leiter als auch zur Energieversorgung des Stromsensors und der integrierten Logik und der integrierten Funkeinheit bzw. des Transceivers eingesetzt wird. Um die Messung nicht durch die Energiegewinnung bzw. ein Laden eines Energiebuffers, welcher ausreichend Energie für den laufenden Betrieb der Sensoreinheit bereitstellen und sicherstellen muss, zu beeinflussen, sind beispielsweise getrennte Messphasen und Ladephasen notwendig, welche sich üblicherweise abwechseln. In einer aktiven Messphase kann die Sensoreinheit z.B. einen in der überwachten Leitung auftretenden Fehlerstrom hochauflösend messen und mit Hilfe des aufgeladenen Energiebuffers im Fehlerfall des Energieversorgungsnetzes bzw. der Leitung eine Störungs-/Fehlermeldung drahtlos an z.B. eine übergeordnete Kontrolleinheit oder eine Leitwarte senden. In einer Ladephase, in welcher der Energiebuffer mit Hilfe des Stromwandlers aufgeladen wird, ist die Sensoreinheit üblicherweise inaktiv. D.h. sie kann weder Daten messen noch übertragen, da die integrierte Logik und die Funkeinheit üblicherweise stromlos geschalten sind. Erst nach Aufladen des Energiebuffers wechselt die Sensoreinheit wieder in die Messphase. Eine derartige Sensoreinheit weist damit den Nachteil auf, dass ein Fehlerstrom, welcher während einer Ladephase der Sensoreinheit auftritt, nicht mittels des Messwandlers gemessen und damit nicht detektiert werden kann. Tritt weiterhin ein Fehlerfall auf der Leitung auf, welcher beispielsweise eine Notabschaltung der Leitung und/oder des Energieversorgungsnetzes bedingt, so wird ein weiteres Aufladen des Energiebuffers der Sensoreinheit verhindert und die Sensoreinheit kann keine Informationen mehr an die übergeordnete Kontrolleinheit bzw. die Leitwarte übertragen.

Die Veröffentlichung DE 11 2010 001638 B4 betrifft im Allgemeinen die Messung des Stromverbrauchs und insbesondere eine nicht invasive und eigengespeiste Messung elektrischen Stroms, der durch eine Stromleitung fließt, um eine Analyse des Stromverbrauchs auf einer Basis pro Trennschalter zu ermöglichen.

Die Veröffentlichung DE 10 2018 106940 A1 betrifft eine Messvorrichtung zur verteilten Strom- und Spannungsmessung stromdurchflossener Leiter.

In der Veröffentlichung US 2013/321965 A1 ist ein Fehlerstromschutzschalter beschrieben, welcher zur Ermittlung eines Fehlerstromsignals konfiguriert ist. Der Fehlerstromschutzschalter ist dazu ausgelegt, bei Erkennen eines Fehlerstroms größer als ein vorgebbarer Auslösestrom ein Öffnen der Schaltkontakte zu bewirken. Eine erste Schaltungsanordnung ist dazu ausgelegt, ein Auslösen des Fehlerstromschutzschalters zu verhindern, wenn ein Fehlerstrom auftritt, dessen Dauer kürzer als eine halbe Periode einer Netzfrequenz eines zugehörigen Stromnetzes ist.

Die Veröffentlichung US 2012/249151 A1 beschreibt einen kompakten Fehlerstromschutzschalter zur Funktionsprüfung ohne Unterbrechung des nachgeschalteten Stromnetzes, umfassend zwei getrennte Auslösekreise, wobei ein erster Auslösekreis unabhängig von der Netzspannung und ein zweiter Auslösekreis von der Netzspannung abhängig ist. Bei der Funktionsprüfung überwacht einer der Auslösekreise bzw. der jeweils andere Auslösekreis das zu schützende elektrische Netz auf Fehlerströme.

Die Veröffentlichung US 2004/183522 A1 offenbart eine Vorrichtung zum Erfassen des Stroms in einer Stromleitung eines Energiesystems. Die Vorrichtung bezieht sich insbesondere auf das Gebiet der Stromsensoren, die zur Überwachung des Stromflusses in Energiesystemen verwendet werden, im Speziellen auf ein selbstversorgtes oder fernversorgtes Stromsensorgerät, das ein Ausgangssignal liefert.

### Darstellung der Erfindung

Der Erfindung liegt daher die Aufgabe zugrunde, eine Sensoreinheit sowie ein Verfahren zum Erkennen von Fehlerströmen in einem Energieversorgungsnetz anzugeben, durch welche auch während einer Ladephase der Sensoreinheit Fehlerströme im zu überwachenden Leiter erkannt und Fehlermeldungen übertragen werden können.

Diese Aufgabe wird durch eine Sensoreinheit und ein Verfahren eingangs genannter Art mit den Merkmalen der unabhängigen Patentansprüche gelöst. Vorteilhafte Ausführungsformen der vorliegenden Erfindung sind in den abhängigen Ansprüchen beschrieben.

Erfindungsgemäß erfolgt die Lösung der Aufgabe durch eine Sensoreinheit, mit welcher Fehlerströme in einem zu überwachenden Leiter eines Energieversorgungsnetzes (z.B. Mittelspannungsnetz oder Niederspannungsnetz) erkannt werden. Eine derartige Sensoreinheit weist zumindest auf:
- einen Stromwandler, welcher sowohl zum Ermitteln eines Stroms in einem zu überwachenden Leiter des Energieversorgungsnetzes in einer Messphase als auch zum Aufladen der Sensoreinheit in einer Ladephase eingesetzt wird;
- einen Lastwiderstand, über welchen in der Messphase der Strom im zu überwachenden Leiter ermittelbar ist;
- einen Energiebuffer für eine interne Energieversorgung der Sensoreinheit, welcher über eine Ladeschaltung in der Ladephase aufgeladen wird;
- und eine elektronische Einheit zur Ansteuerung der Sensoreinheit und zum Auswerten und Übertragen von Messergebnissen.

Weiterhin ist die elektronische Einheit der Sensoreinheit dazu eingerichtet, eine Ladespannung am Energiebuffer zu überwachen bzw. laufend zu messen und mit einem oberen Schwellwert und einem unteren Schwellwert zu vergleichen. Weiterhin weist die Sensoreinheit zwei Schaltelemente auf, welche durch die elektronische Einheit derart angesteuert werden, dass bei Erreichen und/oder Überschreiten des oberen Schwellwerts durch die Ladespannung am Energiebuffer ein erstes Schaltelement geschlossen wird und ein zweites Schaltelement geöffnet wird, wodurch die Sensoreinheit in die Messphase versetzt wird, und dass bei Erreichen und/oder Unterschreiten des unteren Schwellwerts durch die Ladespannung am Energiebuffer das erste Schaltelement geöffnet wird und das zweite Schaltelement geschlossen wird, wodurch die Sensoreinheit in die Ladephase versetzt wird. In der Ladephase der Sensoreinheit wird weiterhin von der elektronischen Einheit die überwachte Ladespannung am Energiebuffer dazu herangezogen, einen Strom bzw. eine Höhe des Stroms im zu überwachenden Leiter zu ermitteln und dadurch Fehlerströme im zu überwachenden Leiter zu erkennen.

Der Hauptaspekt der erfindungsgemäß vorgeschlagenen Lösung besteht darin, dass durch ein Messen und Auswerten der Ladespannung am Energiebuffer der Sensoreinheit während der Ladephase auf einfache Weise auch während der passiven Ladephase, in welcher der Lastwiderstand für ein Messen des Stroms im zu überwachenden Leiter stromlos geschaltet ist, weiterhin der Strom im zu überwachenden Leiter überwacht und damit Fehlerströme bzw. Fehlerfälle erkannt werden können. Eine Überwachung des Stroms im zu überwachenden Leiter ist deshalb möglich, da eine Ladedauer bzw. ein Spannungshub am Energiebuffer proportional zu diesem Strom sind. Zwar sättigt der Stromwandler der Sensoreinheit bei Belastung durch den Energiebuffer, starke Anstiege im Leitungsstrom können allerdings anhand einer daraus resultierenden Veränderung der Ladekurve des Energiebuffers und damit aus einer Messung der Ladespannung am Energiebuffer erkannt werden. Bei entsprechender Kenntnis der Bauteileigenschaften (z.B. Hysterese des Stromwandlers, Stromverbrauch der elektronischen Einheit, etc.) und je nach geeigneter Wahl der Bauteile für die Sensoreinheit kann so zumindest grob eine Größe des Stroms, insbesondere eines Fehlerstroms, im zu überwachenden Leiter erkannt und abgeschätzt werden. Damit können durch die vorgeschlagene Sensoreinheit auch während der Ladephase Fehlerströme und Fehlerfälle wie Störungen des zu überwachenden Leiters rasch und einfach erkannt werden.

Weiterhin bietet die vorgeschlagene Sensoreinheit neben dem Erkennen von Fehlerströmen in der überwachten Leitung auch den Vorteil, dass stromlose Leiter, z.B. Freileitungen, erkannt werden. Steigt beispielsweise die Ladespannung des Energiebuffers eine gewisse Zeit während der Ladephase nur in geringem Maße oder gar nicht mehr an, so deutet dies auf einen stromlosen Leiter hin. Die Sensoreinheit kann dann beispielsweise mit Hilfe der Restenergie im Energiebuffer eine entsprechende Fehlermeldung absetzen.

Mit Hilfe der Sensoreinheit besteht damit die Möglichkeit, nicht nur während der Messphase der Sensoreinheit, sondern auch während der Ladephase Fehlerfälle und/oder Störungen in einer Leitung eines Energieversorgungsnetzes rasch zu erkennen und zu melden. Es kann damit eine präzisere Fehlerlokalisierung im Energieversorgungsnetz vorgenommen werden. Idealerweise können für detailliertere Informationen (z.B. Störmeldung, etc.) zu aufgetretenen Fehlern z.B. zusätzlich von Nachbarsensoren der Sensoreinheiten weitere Informationen übertragen werden. Dabei können die Sensoreinheiten im Energieversorgungsnetz derart synchronisiert sein, dass sich benachbarte Sensoreinheiten nicht zeitgleich in der Ladephase befinden, wodurch eine exaktere Lokalisierung sowie eine qualitativ hochwertige Messung im Fehlerfall (z.B. hohe Fehlerströme, stromlose Leitung, etc.) möglich ist. Ein Leiter kann damit im Fehlerfall selektiv abgeschaltet werden und dadurch Personensicherheit sichergestellt, Betriebsmittel geschont und von einem Störfall betroffenen Kunden möglichst geringgehalten werden.

Es ist von Vorteil, wenn der untere Schwellwert der Ladespannung am Energiebuffer derart festgelegt ist, dass im Energiebuffer eine Energiemenge für einen reduzierten Betrieb der Sensoreinheit während der Ladephase verfügbar ist. Weiterhin ist es von Vorteil, dass der obere Schwellwert der Ladespannung am Energiebuffer derart festgelegt ist, dass der Energiebuffer für ein hochauflösendes Messen des Stroms im zu überwachenden Leiter und die Übertragung der Messergebnisse aufgeladen ist. Durch die bei Erreichen und/oder Unterschreiten des unteren Schwellwerts im Energiebuffer befindliche Restenergiemenge wird auf einfache Weise sichergestellt, dass die Sensoreinheit mit reduziertem Stromverbrauch weiterarbeiten kann. D.h. es kann während der Ladephase weiterhin die Ladespannung am Energiebuffer (gegebenenfalls mit reduzierter Frequenz) überwacht und in Bezug auf Fehlerströme im zu überwachenden Leiter ausgewertet werden. Weiterhin können mit der vorhandenen Restenergie zumindest kurze Datenpakete als Fehlermeldungen abgesendet werden. Bei Erreichen bzw. Überschreiten des oberen Schwellwerts ist die Ladespannung hoch genug, damit die Sensoreinheit in die Messphase wechseln kann. D.h. der Energiebuffer ist für ein genaues und hochauflösendes Messen und ein Übertragen der Messergebnisse in vollem Umfang aufgeladen.

Eine zweckmäßige Ausgestaltung der Sensoreinheit sieht vor, dass die elektronische Einheit der Sensoreinheit zumindest eine Ansteuerung, durch welche die zwei Schaltelemente mittels Ansteuersignalen gegengleich ansteuerbar sind, eine Messschaltung zum Verarbeiten und Auswerten von Messwerten und der Ladespannung am Energiebuffer sowie ein Funkmodul zum Übertragen von Messergebnissen, welche aus den Messwerten und der gemessenen Ladespannung ableitbar sind, aufweist. Dazu kann die elektronische Einheit idealerweise als digitale Logik (z.B. als Mikrocontroller) ausgestaltet sein, welcher das Funkmodul zum Übertragen der Messergebnisse zugeordnet ist oder in welche das Funkmodul zum Übertragen der Messergebnisse integriert ist.

Weiterhin ist die Messschaltung der elektronischen Einheit idealerweise dazu eingerichtet, dass während der Messphase aus Messwerten am Lastwiderstand der Sensoreinheit der Strom bzw. eine Stromhöhe und/oder Fehlerströme im zu überwachenden Leiter des Energieversorgungsnetzen ermittelt werden. Außerdem ist es günstig, wenn die Messschaltung der elektronischen Einheit auch dazu eingerichtet ist, dass während der Ladephase die Ladespannung am Energiebuffer zum Erkennen einer Höhe des Stroms und/oder zum Erkennen von Fehlerströmen im zu überwachenden Leiter des Energieversorgungsnetzes verwendet wird. Auf diese Weise können sowohl während der Messphase als auch während der Ladephase Fehlerströme im zu überwachenden Leiter von der Sensoreinheit rasch erkannt werden und einen Fehlerlokalisierung im Energieversorgungsnetz verbessert werden.

Eine zweckmäßige Weiterbildung der Sensoreinheit sieht vor, dass die Sensoreinheit weiterhin eine Spannungsversorgungsschaltung aufweist, über welcher die elektronische Einheit mit einer entsprechenden, stabilisierten Spannung aus dem Energiebuffer versorgt wird. Die Spannungsversorgungsschaltung kann beispielweise als Gleichspannungs- bzw. DC-DC-Wandler ausgeführt sein. Mit Hilfe der Spannungsversorgungsschaltung kann die Versorgungsspannung für die elektronische Einheit der Sensoreinheit sehr einfach auf einen vorgegebenen Wert eingestellt und stabil gehalten werden.

Weiterhin ist es günstig, wenn für eine drahtlose Übertragung der Messergebnisse der Sensoreinheit eine Funktechnologie mit niedrigem Energiebedarf und hoher Reichweite vorgesehen ist. Dadurch wird für die Übertragung der Messergebnisse, wie z.B. Messwerte des Stroms im zu überwachenden Leiter, Fehlermeldungen bei Erkennen eines Fehlerstroms, Störungsmeldungen z.B. bei Kurzschluss, Erdschluss, Leiterbruch, etc. möglichst wenige Energie von der Sensoreinheit verbraucht, wodurch z.B. eine aktive Messphase der Sensoreinheit im Verhältnis zur passiven Ladephase der Sensoreinheit deutlich länger dauern kann. Als Funktechnologie kann z.B. die so genannte Narrowband-Internet of Things- bzw. Narrowband-IoT-Funktechnologie eingesetzt werden, welche eine Funktechnologie für weitläufige Funknetze mit geringem Energieverbrauch insbesondere im industriellen Umfeld darstellt. Narrowband-IoT verwendet einen Unterbereich des Mobilfunkstandards Long Term Evolution (kurz: LTE).

Idealerweise sind die zwei Schaltelemente der Sensoreinheit als Transistoren, Feldeffekttransistoren oder Halbleiterschalter ausgeführt. Als Energiebuffer kann in vorteilhafter Weise ein Kondensator, insbesondere ein so genannter Superkondensator (kurz: SuperCap) oder Ultrakondensator eingesetzt werden, welche sehr schnell ge- und entladen werden können und wesentlich mehr Schaltzyklen als Akkumulatoren überstehen. Ein Einsatzgebiet von Superkondensatoren reicht von der Bereitstellung von kleinsten Strömen zum Aufrechterhalten eines Dateninhalts in statischen Speichereinheiten in elektronischen Geräten bis zu einem Einsatz in der Leistungselektronik - z.B. als Energiebuffer.

Die Lösung der genannten Aufgabe erfolgt auch durch ein Verfahren zum Erkennen von Fehlerströmen in einem Energieversorgungsnetz, welches von der Sensoreinheit durchgeführt wird. Dabei wird während einer aktiven Messphase der Sensoreinheit ein Strom in einem zu überwachenden Leiter des Energieversorgungsnetzes mit Hilfe eines Lastwiderstands ermittelt und während einer passiven Ladephase der Sensoreinheit ein Energiebuffer für die interne Energieversorgung der Sensoreinheit über eine Ladeschaltung aufgeladen. Dazu wird eine Ladespannung am Energiebuffer der Sensoreinheit überwacht bzw. laufend gemessen und mit einem oberen Schwellwert und einem unteren Schwellwert verglichen. Bei Erreichen und/oder Überschreiten des oberen Schwellwerts durch die Ladespannung wird ein erstes Schaltelement der Sensoreinheit geschlossen und ein zweites Schaltelement der Sensoreinheit geöffnet, wodurch die Sensoreinheit in die Messphase versetzt wird. Bei Erreichen und/oder Unterschreiten des unteren Schwellwerts durch die Ladespannung wird das erste Schaltelement der Sensoreinheit geöffnet und das zweite Schaltelement der Sensoreinheit geschlossen, wodurch die Sensoreinheit in die Ladephase versetzt wird. Zusätzlich wird während der Ladephase der Sensoreinheit die Ladespannung am Energiebuffer weiterhin gemessen und aus der gemessenen Ladespannung ein Strom bzw. eine Höhe des Stroms im zu überwachenden Leiter des Energieversorgungsnetzes abgeleitet, um auch während der Ladephase der Sensoreinheit Fehlerströme, Störungen und Fehlerfälle im zu überwachenden Leiter zu erkennen.

Der Vorteil des erfindungsgemäß vorgeschlagenen Verfahrens besteht darin, dass auch während der Ladephase der Sensoreinheit Fehlerströme im zu überwachenden Leiter bzw. Fehlerfälle, Störungen (z.B. Erdschluss, Kurzschluss, etc.) sowie ein stromloser Leiter - durch ein Messen und Auswerten der Ladespannung am Energiebuffer der Sensoreinheit - auf einfache und rasche Weise erkannt werden können. Das Verfahren ermöglicht weiterhin eine präzise Fehlerlokalisierung im Energieversorgungsnetz, da von einer Sensoreinheit auch in der Ladephase ein Fehlerstrom detektiert und eine entsprechende Meldung z.B. an eine Kontrolleinheit oder Leitwarte übertragen werden kann.

Es ist dabei günstig, wenn der untere Schwellwert für die Ladespannung derart festgelegt wird, dass vom Energiebuffer der Sensoreinheit während der Ladephase eine Energiemenge zur Verfügung gestellt wird, mit welcher die Sensoreinheit während der Ladephase mit einer reduzierten Messfrequenz betrieben werden kann und Messergebnisse in einem reduzierten Umfang übertragen werden können.

Weiterhin ist es von Vorteil, wenn der obere Schwellwert für der Ladespannung am Energiebuffer derart festgelegt wird, dass der Energiebuffer mit einer Energiemenge geladen ist, mit welcher von der Sensoreinheit während der Messphase hochauflösend gemessen werden kann und Messergebnisse übertragen werden können.

Es ist weiterhin vorteilhaft, wenn die Messergebnisse, welche während der Messphase und während der Ladephase ermittelt werden, von der Sensoreinheit drahtlos mittels einer Funktechnologie mit geringem Energieverbrauch und großer Reichweite an eine übergeordnete Kontrolleinheit übertragen werden. Auf diese Weise kann ein Energiebedarf für die Übertragung der Messergebnisse z.B. an eine übergeordnete Kontrolleinheit oder eine Leitwarte geringgehalten werden. Dadurch kann einerseits die aktive Messphase der Sensoreinheit im Verhältnis zur passiven Ladephase der Sensoreinheit deutlich länger dauern kann. Andererseits können auch noch während der passiven Ladephase Messergebnisse in reduziertem Umfang (z.B. Datenpakete mit Fehler-/Störungsmeldungen mit reduzierter Paketgröße) mit der durch den unteren Schwellwert für die Ladespannung definierten Energiemenge versendet werden.

Es ist außerdem günstig, wenn für eine Erkennung eines Fehlerstroms in der Ladephase der Sensoreinheit ein Vergleich mit lokal und/oder zentral abgelegten, historischen Daten der Ladephase der Sensoreinheit durchgeführt wird. Mit Hilfe von Vergleichen von historischen Daten - z.B. in Form von lokal oder zentral erlernten Profilen (z.B. Tagesprofilen des Mess- und Ladephasen der Sensoreinheit, etc.) können Abweichungen, welche anhand der Ladespannung in der Ladephase erkennt wurden, einfacher überprüft und Fehlerströme im zu überwachenden Leiter leichter erkannt werden.

Weiterhin kann idealerweise auch vorgesehen sein, dass für eine Erkennung eines Fehlerstroms in der Ladephase der Sensoreinheit ein Vergleich mit Messdaten von weiteren im Energieversorgungsnetz angebrachten, idealerweise benachbarten Sensoreinheiten durchgeführt wird. Diese Messdaten können idealerweise mit einer Funktechnologie mit niedrigem Energiebedarf und geringer Reichweite, eine so genannte Low-Power-Low-Range-Technologie, wie z.B. Bluetooth Low Energy (kurz: BLE) oder ZigBee, an die Sensoreinheit beispielsweise während einer Messphase übertragen und in der Sensoreinheit für den Vergleich in der Ladephase gespeichert werden. Als weitere Sensoreinheiten können beispielsweise Sensoreinheiten verwendet werden, welche auf anderen Leitungsphasen, aber innerhalb desselben Leitungsabschnitts des Energieversorgungsnetzes angebracht sind. Mit Hilfe der Messdaten der anderen, meist benachbarten Sensoreinheiten können dann Abweichungen, welche von der Sensoreinheit in der Ladephase anhand der Ladespannung erkannt wurden, besser interpretiert werden.

### Kurzbeschreibung der Zeichnung

Die Erfindung wird nachfolgend in beispielhafter Weise anhand der beigefügten Figuren erläutert. Es zeigen:
Figur 1 schematisch eine beispielhafte Anordnung einer erfindungsgemäßen Sensoreinheit zum Detektieren von Fehlerströmen in einem Energieversorgungsnetz;
Figur 2 beispielhaft einen Ablauf des Verfahrens zum lückenlosen Erkennen von Fehlerströmen in einem Energieversorgungsnetz unter Verwendung der erfindungsgemäßen Sensoreinheit;
Figur 3 schematisch eine beispielhafte Anwendung der erfindungsgemäßen Sensoreinheit in einem Energieversorgungsnetz.

### Ausführung der Erfindung

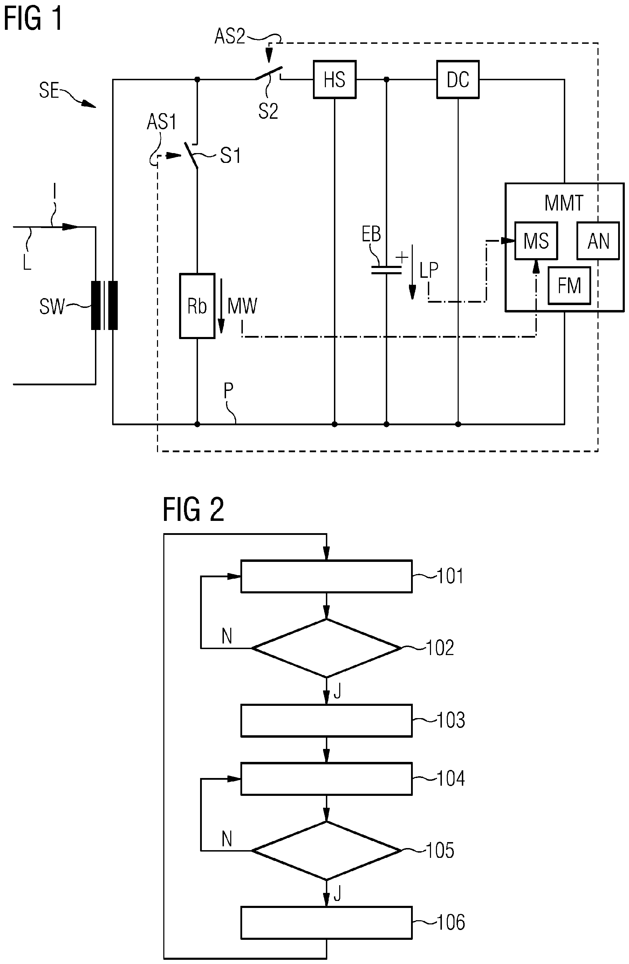

Figur 1 zeigt in schematischer Weise eine Darstellung einer beispielhaften Anordnung einer Sensoreinheit SE, durch welche mittels induktiver Ankopplung an einen Leiter (z.B. Kabel, Freileitung, etc.) eines Energieversorgungsnetzes, insbesondere eines Mittel- oder Niederspannungsnetzes, ein Strom I gemessen werden kann, welcher durch den Leiter L des Energieversorgungsnetzes fließt. Aus der Messung des Stroms I kann dann von der Sensoreinheit SE eine mögliche Störung des Leiters L bzw. ein Fehlerfall im Energieversorgungsnetz (z.B. Beschädigung des Leiters L, Kurzschluss, Erdschluss, etc.) abgeleitet werden. Für die induktive, nicht invasive Ankopplung der Sensoreinheit SE an den Leiter L des Energieversorgungsnetzes weist die Sensoreinheit SE einen Stromwandler SW auf. Der Leiter L des Energieversorgungsnetzes bildet die Primärseite des Stromwandlers SW, dessen Sekundärseite der Sensoreinheit SE verbunden ist. Dabei ist der Stromwandler SW an den jeweiligen Leiter L angepasst - d.h. ein Übersetzungsverhältnis des Stromwandlers SW ist gemäß den im Leiter L zu erwartenden Strömen I ausgestaltet.

Die Sensoreinheit SE ist derart ausgestaltet, dass die Sensoreinheit SE aus der zugeführten elektrischen Energie des Stromwandlers SW z.B. eine Höhe des Stroms I des Leiters L ermittelt und die ermittelte Höhe des Stroms I beispielsweise digitalisiert und drahtlos z.B. einer übergeordneten Kontrolleinheit als Messergebnis zur Verfügung stellt und/oder anhand der ermittelten Höhe des Stroms I einen Fehlerstrom im Leiter L erkennt und als Messergebnis an die übergeordnete Kontrolleinheit eine entsprechende Meldung (z.B. Fehlermeldung, Störungsmeldung) drahtlos sendet.

Die Sensoreinheit SE kann beispielsweise derart realisiert sein, dass die Sekundärseite des Stromwandlers SW mit einer Gleichrichterschaltung, welche der Einfachheit halber in Figur 1 nicht dargestellt ist, verbunden ist. Parallel zur Sekundärseite des Stromwandlers SW ist eine Serienschaltung eines ersten Schaltelements S1 und einem Lastwiderstand bzw. einer Bürde Rb angeordnet, wobei der Lastwiderstand Rb einerseits mit dem ersten Schaltelement S1 und andererseits mit einem gemeinsamen Potential P verbunden ist. Als erstes Schaltelement S1 kann beispielsweise ein Transistor, ein Feldeffekttransistor, Halbleiterschalter oder ähnliches verwendet werden. In einer Messphase der Sensoreinheit SE fließt über den Lastwiderstand Rb ein Strom, durch welchen ein Spannungsabfall als Messwert MW am Lastwiderstand Rb erzeugt wird, aus welchem z.B. eine Höhe des Stroms I im Leiter L abgeleitet werden kann.

Weiterhin ist in Serie zur Sekundärseite des Stromwandlers SW bzw. zur nicht dargestellten Gleichrichterschaltung ein zweites Schaltelement S2 angeordnet, welches mit einem ersten Anschluss auch mit der Serienschaltung aus erstem Schaltelement S1 und Lastwiderstand Rb verbunden ist. Als zweites Schaltelement S2 kann ebenfalls ein Transistor, Feldeffekttransistor, Halbleiterschalter oder ähnliches verwendet werden. An einem zweiten Anschluss des zweiten Schaltelements S2 ist eine Ladeschaltung HS angeschlossen. Die Ladeschaltung HS ist z.B. über einen Anschluss mit dem gemeinsamen Potential P und über einen weiteren Anschluss mit einem ersten Anschluss eines Energiebuffers EB verbunden. Der Energiebuffer EB kann in einer Ladephase der Sensoreinheit SE über die Ladeschaltung HS mittels der über den Stromwandler SW zur Verfügung gestellten Energie geladen werden. Mit einem zweiten Anschluss ist der Energiebuffer EB ebenfalls mit dem gemeinsamen Potential P verbunden. Als Energiebuffer EB kann z.B. ein Kondensator, idealerweise ein Superkondensator oder Ultrakondensator, verwendet werden.

Weiterhin ist an den weiteren Anschluss der Ladeschaltung HS eine Spannungsversorgungsschaltung DC verbunden, welche ebenfalls über einem Anschluss an das gemeinsame Potential P angebunden ist. Von der Spannungsversorgungsschaltung DC wird einer daran angebundenen elektronischen Einheit MMT zur Ansteuerung der Schaltelemente S1, S2 der Sensoreinheit SE und zum Auswerten und Übertragen von Messergebnissen (z.B. Messwerte des Strom I im Leiter L, Fehlermeldungen, Störungsmeldungen, etc.) mit einer entsprechenden, üblicherweise stabilisierten Spannung versorgt, welche vom Energiebuffer EB zur Verfügung gestellt wird. Als Spannungsversorgungsschaltung DC kann beispielsweise ein Gleichspannungswandler bzw. ein so genannter DC-DC-Wandler eingesetzt werden.

Die elektronische Einheit MMT ist dazu eingerichtet, eine Ladespannung LP am Energiebuffer EB zu überwachen bzw. laufend zu messen und mit einem vorgegebenen oberen und einem vorgegebenen unteren Schwellwert für die Ladespannung LP zu vergleichen. Weiterhin ist die elektronische Einheit MMT dazu eingerichtet, das erste Schaltelement S1 und das zweite Schaltelement S2 derart anzusteuern, um die Sensoreinheit SE von der Ladephase in die Messphase und von der Messphase in die Ladephase zu versetzen. Dazu wird beispielsweise die gemessene Ladespannung LP mit dem oberen und den unteren Schwellwert für die Ladespannung LP verglichen.

Wird von der gemessenen Ladespannung LP am Energiebuffer EB der obere Schwellwert erreicht und/oder überschritten, so wird über entsprechenden Ansteuersignale AS1, AS2 der elektronischen Einheit MMT das erste Schaltelement S1 geschlossen und das zweite Schaltelement S2 geöffnet. Die Sensoreinheit SE wird in die Messphase versetzt, in welcher anhand von Messwerten MW am Lastwiderstand Rb die Höhe des Stroms I im zu überwachenden Leiter L ermittelt und damit Fehlerströme durch entsprechende Auswertung erkannt werden können. Der obere Schwellwert der Ladespannung LP am Energiebuffer EB ist dabei derart festgelegt, dass der Energiebuffer EB für ein hochauflösendes Messen des Stroms I im zu überwachenden Leiter L und die Übertragung der aus den Messwerten MW abgeleiteten Messergebnisse ausreichend aufgeladen ist.

Wird von der Ladespannung LP am Energiebuffer EB allerdings der untere Schwellwert erreicht bzw. unterschritten, so wird über die entsprechenden Ansteuersignale AS1, AS2 der elektronischen Einheit MMT das erste Schaltelement S1 geöffnet und das zweite Schaltelement S2 geschlossen. Dadurch wird die Sensoreinheit SE von der Messphase in die Ladephase versetzt. D.h. der Energiebuffer EB wird über die Ladeschaltung HS mittels der vom Stromwandler SW zur Verfügung gestellten Energie geladen. Dabei wird allerdings weiterhin die Ladespannung LP am Energiebuffer EB gemessen und ausgewertet, um aus der Ladespannung den Strom I im zu überwachenden Leiter L bzw. möglicherweise auftretenden Fehlerströme erkennen zu können und entsprechende Messergebnisse, wie z.B. Fehler- und/oder Störungsmeldungen mit reduziertem Datenumfang, z.B. an eine übergeordnete Kontrolleinheit und/oder Leitwarte weiterleiten zu können. Der untere Schwellwert der Ladespannung LP am Energiebuffer EB zum Schalten von der Messphase in die Ladephase ist dabei so festgelegt, dass im Energiebuffer EB eine restliche Energiemenge für einen reduzierten Betrieb der Sensoreinheit SE während der Ladephase verfügbar ist, mit welcher bei reduziertem Stromverbrauch von der Sensoreinheit SE mit reduzierter Frequenz gemessen, ausgewertet und Messergebnisse mit reduziertem Umfang (z.B. kurze Datenpakete mit Informationen zum Detektieren Fehler, etc.) übertragen werden können.

Dazu kann die elektronische Einheit MMT der Sensoreinheit SE beispielsweise eine Ansteuerung AN zum Ansteuern des ersten und des zweiten Schaltelements S1, S2, eine Messschaltung MS zum Verarbeiten und Auswerten von Messwerten MW am Lastwiderstand Rb und der Ladespannung LP am Energiebuffer EB sowie eine Funkeinheit FM zum Übertragen von Messergebnissen aufweisen. Mit der Ansteuerung AN der elektronischen Einheit MMT werden mittels entsprechender Steuersignale AS1, AS2 die Schaltelemente S1, S2 jeweils gegengleich für ein Umschalten zwischen Messphase und Ladephase der Sensoreinheit SE angesteuert. Dazu wird das erste Schaltelement S1 mit dem ersten Steuersignals AS1 und das zweite Schaltelement S2 mit dem zweiten Steuersignals AS2 angesteuert. Für eine so genannte Kaltstartfähigkeit der Sensoreinheit SE sind die Schaltelemente S1, S2 derart geschaltet, dass sich die Sensoreinheit SE beim Einschalten bzw. Anschalten an den Leiter L in der Ladephase befindet. D.h. das erste Schaltelement S1 ist offen und das zweite Schaltelement S2 ist geschlossen in einem stromlosen Zustand der Sensoreinheit SE.

Die Messschaltung MS der elektronischen Einheit MMT kann dazu eingesetzt werden, in der Messphase aus den Messwerten MW am Lastwiderstand Rb beispielsweise eine Höhe bzw. den Strom I im Leiter L zu ermitteln und daraus z.B. Fehlerströme im Leiter L zu erkennen. Während der Ladephase kann die Messschaltung MS die Messwerte der Ladespannung LP am Energiebuffer EB heranziehen, um daraus beispielsweise eine Höhe des Stroms I bzw. Fehlerströme im zu überwachenden Leiter L abzuleiten.

Die aus den Messwerten MW bzw. den Messwerten der Ladespannung LP abgeleiteten Messergebnisse, welche z.B. Daten und/oder Informationen wie Messwerte des Stroms I im Leiter L, Fehlermeldungen, Störmeldungen, etc. umfassen können, können dann vom Funkmodul FM drahtlos z.B. an eine übergeordnete Kontrolleinheit und/oder eine Leitwarte weitergeleitet werden. Die elektronische Einheit MMT kann dabei als digitale Logik, insbesondere als Mikrocontroller ausgestaltet sein, durch welche z.B. die Ansteuerung AN und die Messschaltung MS realisiert sind. Das Funkmodul FM kann dabei der digitalen Logik beispielsweise zugeordnet oder in die digitale Logik integriert sein.

Als Funkmodul FM kann beispielsweise ein Funkmodul FM mit geringem Energieverbrauch und relativ weiter Reichweite eingesetzt werden (z.B. ein Low-Power-Long-Rang-Funkmodul für Narrowband IoT-Funktechnologie). Die drahtlose Datenübertragung von der Sensoreinheit SE zur übergeordneten Kontrolleinheit kann allerdings auch mittels Funktechnologien wie z.B. LTE, GPRS, etc. oder über ein privates Netz des Versorgungsnetzbetreibers erfolgen. Weiterhin kann das Funkmodul FM dazu eingerichtet sein, Messdaten mit weiteren, im Energieversorgungsnetz angebrachten Sensoreinheiten SE, insbesondere benachbarten Sensoreinheiten SE mittels einer Funktechnologie mit niedrigem Energiebedarf und geringer Reichweite (z.B. Bluetooth, ZigBee, etc.) auszutauschen.

Figur 2 zeigt schematisch und beispielhaft einen Ablauf des Verfahrens zum lückenlosen Erkennen von Fehlerströmen in einem Energieversorgungsnetz unter Verwendung der Sensoreinheit SE. Die Sensoreinheit SE befindet sich beispielsweise in der Ladephase, wie z.B. nach einem Einschalten bzw. erstmaligen Anschalten der Sensoreinheit SE an den Leiter L - d.h. bei einem so genannten Kaltstart. D.h. der Energiebuffer EB ist über das zweite Schaltelement S2 mit der Sekundärseite des Stromwandlers SW verbunden und wird über die Ladeschaltung HS mit einer Ladespannung LP geladen, um die elektronische Einheit MMT intern mit Energie versorgen. Weiterhin ist das erste Schaltelement S1 geöffnet, wodurch der Lastwiderstand Rb vom Stromwandler SW getrennt ist und keine Messwerte MW am Lastwiderstand Rb generiert werden.

Beim Umschalten aus der Messphase ist im Energiebuffer EB üblicherweise zumindest so viel Energie gespeichert, um einen reduzierten Betrieb der Sensoreinheit SE - beispielsweise eine Messung der Ladespannung LP am Energiebuffer EB mit reduzierter Messfrequenz - zu ermöglichen. Beim Einschalten bzw. erstmaligen Anschalten oder Kaltstart der Sensoreinheit SE muss der Energiebuffer EB zuerst für den reduzierten Betrieb mit einer Energiemenge (z.B. auf den unteren Schwellwert der Ladespannung) geladen werden, um die elektronische Einheit MMT mit ausreichend Energie für den reduzierten Betrieb während der Ladephase zu versorgen, da beim Kaltstart im Energiebuffer EB üblicherweise kaum bzw. keine Energie gespeichert ist.

In einem ersten Auswerteschritt 101 wird die Ladespannung LP am Energiebuffer EB der Sensoreinheit SE von der elektronischen Einheit MMT bzw. von der Messschaltung MS der elektronischen Einheit MMT gemessen und die gemessene Ladespannung LP mit einem oberen Schwellwert für die Ladespannung LP verglichen. Der obere Schwellwert der Ladespannung LP am Energiebuffer EB kann dabei derart festgelegt werden, dass der Energiebuffer EB mit einer Energiemenge geladen ist, welche ausreicht, um mit der Sensoreinheit SE während der Messphase hochauflösend bzw. mit hoher Messfrequenz zu messen und die Messergebnisse, vor allem im Fehlerfall, in der Gesamtheit übertragen zu können. D.h. der obere Schwellwert der Ladespannung LP ist beispielsweise dann erreicht, wenn der Energiebuffer ausreichend bzw. voll aufgeladen ist.

Wird in einem ersten Überprüfungsschritt 102 festgestellt, dass die Ladespannung LP am Energiebuffer EB den oberen Schwellwert erreicht und/oder überschritten hat - d.h. der Energiebuffer EB ist ausreichend geladen, so wird die Sensoreinheit SE in einem Umschaltschritt 103 in die Messphase geschalten. Dazu wird das erste Schaltelement S1 durch ein entsprechendes ersten Ansteuersignal AS1 geschlossen und das zweite Schaltelement S2 durch ein entsprechendes Ansteuersignal AS2 der Ansteuerung AN geöffnet.

In der Messphase ist der Lastwiderstand Rb durch das geschlossene, erste Schaltelement S1 mit dem Stromwandler SW verbunden. Es fließt damit ein Strom durch den Lastwiderstand Rb, welcher einen Spannungsabfall erzeugt, der vom Strom durch den Lastwiderstand Rb abhängt. D.h. in der Messphase kann z.B. der Spannungsabfall am Lastwiderstand Rb oder der Strom durch den Lastwiderstand RB als Messwert MW herangezogen werden, um den Strom I im Leiter L z.B. in der Messschaltung MS der elektronischen Einheit MMT zu ermitteln bzw. einen Fehlerstrom im Leiter L zu erkennen. D.h. in der Messphase wird von der Sensoreinheit SE hochauflösend gemessen und es werden beispielsweise im Fehlerfall Messergebnisse, wie z.B. die Höhe des Strom I im Leiter, Fehlermeldungen, Störungsmeldungen, etc. z.B. vom Funkmodul FM der elektronischen Einheit MMT an eine übergeordnete Kontrolleinheit und/oder eine Leitwarte übertragen, wobei beispielsweise ein Funktechnologie mit geringem Energieverbrauch und großer Reichweite, wie z.B. die Narrowband IoT-Funktechnologie, verwendet werden kann.

Während der Messphase wird die elektronische Einheit MMT der Sensoreinheit SE über die Spannungsversorgungsschaltung DC aus dem Energiebuffer EB mit elektrischer Energie versorgt. D.h. der Energiebuffer wird zur Energieversorgung der Sensoreinheit SE entladen. Weiterhin wird während der Messphase in einem zweiten Auswerteschritt 104 die Ladespannung LP am Energiebuffer überwacht bzw. gemessen und mit dem unteren Schwellwert für die Ladespannung LP verglichen. Der untere Schwellwert für die Ladespannung ist dabei derart festgelegt, dass im Energiebuffer EB noch ausreichend Energiereserven für einen reduzierten Betrieb der Sensoreinheit SE, vor allem der elektronischen Einheit MMT und der Funkeinheit FM, während der Ladephase zur Verfügung stehen.

Wird in einem zweiten Überprüfungsschritt 105 z.B. von der Messschaltung MS der elektronischen Einheit MMT festgestellt, dass die am Energiebuffer überwachte bzw. gemessene Ladespannung LP den unteren Schwellwert erreicht bzw. unterschritten hat, so wird in einem Umschaltschritt 106 in die Ladephase der Sensoreinheit SE geschaltet. Im Umschaltschritt 106 in die Ladephase wird das erste Schaltelement S1 mittels eines entsprechenden Steuersignals AS1 der Ansteuerung AN geöffnet und das zweite Schaltelement S2 mittels eines entsprechenden zweiten Steuersignals AS2 geschlossen. D.h. der Lastwiderstand Rb wird stromlos geschaltet und die Sekundärseite des Stromwandlers SW wird durch das zweite Schaltelement S2 mit der Ladeschaltung verbunden, um den Energiebuffer EB aufzuladen. Während der Ladephase arbeitet die Sensoreinheit SE mit einem reduzierten Energieverbrauch, wobei die elektronische Einheit MMT zumindest mit der im Energiebuffer EB gespeicherten restlichen Energiemenge z.B. über die Spannungsversorgungsschaltung DC mit Energie versorgt wird.

Während der Ladephase wird weiterhin gemäß dem ersten Auswerteschritt 101 die Ladespannung LP am Energiebuffer EB mit Hilfe der Messschaltung MS überwacht bzw. gemessen. Aus der gemessenen Ladespannung LP am Energiebuffer EB werden von der elektronischen Einheit MMT bzw. der Messschaltung MS mögliche Fehlerströme I im zu überwachenden Leiter L des Energieversorgungsnetzes ermittelt. Da eine Ladedauer bzw. ein Spannungshub am Energiebuffer EB proportional zum Strom I sind, welcher durch den zu überwachenden Leiter L des Energieversorgungsnetzes fließt, kann trotz Sättigung des Stromwandlers SW der Sensoreinheit SE durch eine Belastung mit dem Energiebuffer EB ein starker Anstieg im Leiterstrom I anhand einer daraus resultierenden Veränderung einer Ladekurve des Energiebuffers EB erkannt werden. Bei entsprechender Kenntnis der Bauteileigenschaften der Sensoreinheit SE (z.B. Hysterese des Stromwandlers SW, Stromverbrauch der elektronischen Einheit MMT, etc.) kann so ein Fehlerstrom I im Leiter L erkannt und zumindest grob eine Größe des Fehlerstroms I bestimmt werden.

Weiterhin kann ein Vergleich der überwachten Ladespannung bzw. daraus abgeleiteter Daten der Ladephase mit z.B. historische Daten von früheren Ladephasen der Sensoreinheit SE oder mit Messdaten anderer im Energieversorgungsnetz angebrachten Sensoreinheiten SE zum Erkennen von Fehler- bzw. Störfällen durchgeführt werden. So können beispielsweise hinterlegte oder lokal/zentral erlernte Profile (z.B. Tagesprofil, etc.) zur Fehlererkennung herangezogen werden, wobei z.B. Verlauf und Dauer einer aktuellen Ladephase der Sensoreinheit SE mit dem erlernten Profil bzw. den hinterlegten, historischen Daten verglichen werden, um beispielsweise Fehlerströme zu erkennen und bei z.B. starken Abweichungen einen Fehler zu melden. Alternativ oder zusätzlich könnte z.B. auch ein Vergleich mit Daten anderer Sensoreinheiten SE, welche z.B. im selben Leitungssektor des Energieversorgungsnetzes - d.h. z.B. auf anderen Leitungsphasen, aber im selben Abschnitt des Energieversorgungsnetzes - angeordnet sind, durchgeführt werden, um z.B. Abweichungen zu historischen Daten der Ladephase der Sensoreinheit SE besser interpretieren zu können. Um Messdaten anderer, meist benachbarter Sensoreinheiten SE zu erhalten, kann beispielsweise auf eine Funktechnologie mit niedrigem Energiebedarf und geringer Reichweite - d.h., auf eine Low-Power-Low-Range-Technologie, wie z.B. Bluetooth Low Energy, etc. - zurückgegriffen werden.

Wird während der Ladephase der Sensoreinheit SE ein Fehlerstrom I im Leiter L anhand der am Energiebuffer EB gemessenen Ladespannung LP erkannt, dann wird mit Hilfe der Energiereserve im Energiebuffer EB zumindest eine reduzierte Meldung (z.B. kurzes Datenpaket, etc.) mit Informationen zum detektierten Fehler im Leiter L bzw. im Energieversorgungsnetz übertragen. Für die Datenübertragung z.B. an eine übergeordnete Kontrolleinheit bzw. eine Leitwarte wird wieder das Funkmodul FM der elektronischen Einheit MMT verwendet.

Wird nun in der Ladephase der Sensoreinheit SE - wieder mittels des ersten Überwachungsschritts 102 - festgestellt, dass von der Ladespannung am Energiebuffer EB der oberer Schwellwert erreicht bzw. überschritten wird, so wird die Sensoreinheit SE im Umschaltschritt 103 wieder in die Messphase geschaltet. D.h. der Energiebuffer EB ist z.B. wieder aufgeladen und kann die elektronische Einheit MMT wieder voll mit Energie für einen hochauflösende Messung und eine volle Datenübertragung versorgen.

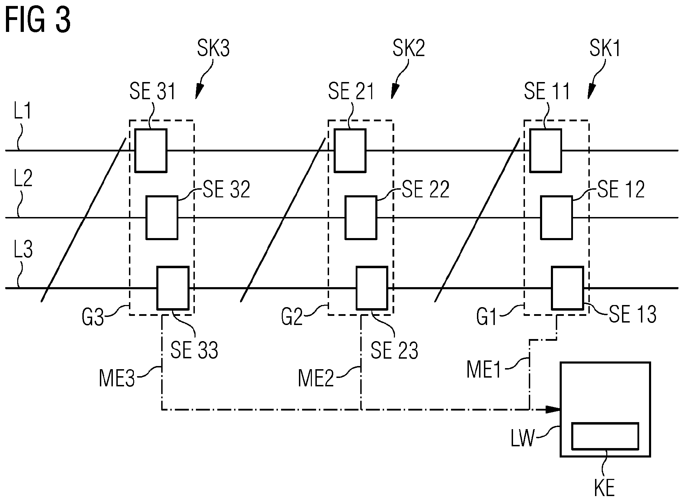

In Figur 3 ist beispielhaft und schematisch eine Anwendungsmöglichkeit der Sensoreinheit aus Figur 1 bzw. des zugehörigen Verfahrens nach Figur 2 dargestellt. Figur 3 zeigt dabei schematisch eine beispielhaftes Energieversorgungsnetz, wie z.B. ein Mittelspannungs- oder Niederspannungsnetz, welches z.B. drei Leiter L1, L2, L3 in Form von Freileitungen aufweist. Das Energieversorgungsnetz ist beispielweise in Leitungssegmente SK1, SK2, SK3 unterteilt. In jedem der Leitungssegmente SK1, SK2, SK3 sind in einem Abstand, welchen z.B. eine Segmentlänge vorgibt, auf jedem der drei Leiter L1, L2, L3 Sensoreinheiten SE11, SE12, SE13, SE21, SE22, SE23, SE31, SE32, SE33 angebracht, welche auch während ihrer Ladephase Fehlerfälle im jeweils überwachten Leiter L1, L2, L3 erkennen können. Die Sensoreinheiten SE11, SE12, SE13, SE21, SE22, SE23, SE31, SE32, SE33 eines Leitersegments SK1, SK2, SK3 können dabei zu Sensorgruppen G1, G2, G3 zusammengefasst werden. So bilden beispielweise die Sensoreinheiten S11, S12, S13 eines ersten Leitersegments SK1 eine erste Sensorgruppe G1, die Sensoreinheiten SE21, SE22, SE23 des zweiten Leitersegments SK2 eine zweite Sensorgruppe G2 und die Sensoreinheiten SE31, SE32, SE33 des dritten Leitersegments SK3 eine dritte Sensorgruppe G3.

Die Sensorgruppen G1, G2, G3 können ihre jeweiligen Messergebnisse ME1, ME2, ME3 (z.B. Messwerte des Stroms im zu überwachenden Leiter L1, L2, L3; Fehlermeldungen, Störungsinformationen, etc.) drahtlos - z.B. mittels einer Low-Power-High-Range-Funktechnologie (z.B. NB-IoT, etc.) an eine Kontrolleinheit KE in einer Leitwarte LW übertragen. In der Leitwarte LW wird dann die Fehlerlokalisation auf Basis der Messergebnisse ME1, ME2, ME3 der Sensoreinheiten SE11, SE12, SE13, SE21, SE22, SE23, SE31, SE32, SE33 bzw. Sensorgruppen G1, G2, G3 von der übergeordneten Kontrolleinheit KE gesteuert.

Für eine optimierte Fehlerlokalisierung können Sensoreinheiten SE11, SE12, SE13, SE21, SE22, SE23, SE31, SE32, SE33 derart synchronisiert werden, dass sich die Ladephasen benachbarter Sensoreinheiten SE11, SE12, SE13, SE21, SE22, SE23, SE31, SE32, SE33 bzw. Sensorgruppen G1, G2, G3 nicht überschneiden, da die Sensoreinheiten SE11, SE12, SE13, SE21, SE22, SE23, SE31, SE32, SE33 in der Ladephase Fehlerströme bzw. Störungen im zu überwachenden Leiter L1, L2, L3 nur in reduziertem Umfang melden können. D.h. um verlässliche Messergebnisse ME1, ME2, ME3 eines Fehlerstroms im Fehlerfall zu haben und um eine Eingrenzung des Fehlerorts zu optimieren, werden über im Folgenden kurze beschriebene Ansätze die jeweiligen Sensoreinheiten SE11, SE12, SE13, SE21, SE22, SE23, SE31, SE32, SE33 und/oder Sensorgruppen G1, G2, G3 derart synchronisiert, dass sich die Sensoreinheiten SE11, SE12, SE13, SE21, SE22, SE23, SE31, SE32, SE33 und/oder Sensorgruppen G1, G2, G3 benachbarter Leitersegmente SK1, SK2, SK3 niemals gleichzeitig der Ladephase befinden. D.h. die Ladephasen benachbarter Sensoreinheiten SE11, SE12, SE13, SE21, SE22, SE23, SE31, SE32, SE33 oder Sensorgruppen G1, G2, G3 sind so abgestimmt, dass sie sich zeitlich nicht überlappen. Idealerweise sind die jeweils zu ladenden Sensoreinheiten SE11, SE12, SE13, SE21, SE22, SE23, SE31, SE32, SE33 gleichmäßig über die Leiter L1, L2, L3 verteilt und es gibt immer eine etwa gleiche Anzahl an Sensoreinheiten SE11, SE12, SE13, SE21, SE22, SE23, SE31, SE32, SE33 in der Ladephase. Befindet sich z.B. die zweite Sensorgruppe G2 in der Ladephase und liefert daher nur reduzierte Messergebnisse ME2, so wird durch die Synchronisierung garantiert, dass die erste und die dritte Sensorgruppe G1, G3 im ersten bzw. dritten Leitersegment SK1, SK3 aktiv sind bzw. sich in der Messphase befinden und detaillierte Messergebnisse ME1, ME3 an die übergeordnete Kontrolleinheit KE für eine Fehlerlokalisierung liefern.

Tritt beispielsweise ein Fehlerfall, wie z.B. ein Kurzschluss oder ein Erdschluss, im dritten Leitersegment SK3 auf und es befindet sich z.B. eine entsprechend betroffene Sensoreinheit SE21, SE22, SE23 der zweiten Sensorgruppe G2 in der Ladephase, so kann eine Fehlerdetektion beispielweise wie folgt erfolgen:
Von den Sensoreinheiten SE11, SE12, SE13, SE21, SE22, SE23 der ersten und zweiten Sensorgruppe G1, G2 wird z.B. ein hoher Fehlerstrom des Fehlerfalls (z.B. Kurzschlussstrom) im jeweils überwachten Leiter L1, L2, L3 detektiert. Dabei wird zwar von der betroffenen Sensoreinheit SE21, SE22, SE23 der zweiten Sensorgruppe G2 aufgrund der Ladephase keinen hochauflösende bzw. genaue Messung durchgeführt, aber es kann zumindest der Fehler erkannt und ein Messergebnis, wie z.B. eine Fehlermeldung, in reduziertem Umfang an die Kontrolleinheit KE gesendet werden. Der Fehlerfall kann dadurch sehr einfach auf das dritte Leitersegment SK3 eingegrenzt werden. Zusätzlich werden von den Sensoreinheiten SE11, SE12, SE13, der ersten Sensorgruppe G1, welche sich aufgrund der Synchronisation nicht zeitgleich mit der zweiten Sensorgruppe G2 in der Ladephase befindet, detaillierte Messergebnisse ME1 des Fehlerfalls an die Kontrolleinheit KE gesendet. Nach Auslösen einer Schutzvorrichtung im Energieversorgungsnetz sind dann z.B. alle Sensorgruppen G1, G2, G3 stromlos.

Um eine Synchronisierung benachbarter Sensoreinheiten SE11, SE12, SE13, SE21, SE22, SE23, SE31, SE32, SE33 bzw. Sensorgruppen G1, G2, G3 zu gewährleisten bzw. ein Überlappen der Ladephase benachbarter Sensoreinheiten SE11, SE12, SE13, SE21, SE22, SE23, SE31, SE32, SE33 bzw. Sensorgruppen G1, G2, G3 zu verhindern, kann beispielsweise eine Synchronisierung zentral - beispielsweise von der Kontrolleinheit KE - durchgeführt werden. Dazu kann z.B. jede Sensoreinheit Sensoreinheiten SE11, SE12, SE13, SE21, SE22, SE23, SE31, SE32, SE33 mittels eines initialen Standardprogramms über einige Zyklen hinweg die jeweilige Dauer der jeweiligen Mess- und Ladephase erlernen und die erlernten Daten zu Mess- und Ladephase an die Kontrollbox übertragen, welche daraus einen entsprechenden Fahrplan für die Sensoreinheiten SE11, SE12, SE13, SE21, SE22, SE23, SE31, SE32, SE33 bzw. Sensorgruppen G1, G2, G3 eines zu kontrollierenden Netzabschnitts erstellt.

Alternativ können für die Synchronisierung der Sensoreinheiten SE11, SE12, SE13, SE21, SE22, SE23, SE31, SE32, SE33 bzw. Sensorgruppen G1, G2, G3 auch evolutionäre Ansätze (kurz: EA) mit stochastischem Verhalten verwendet werden. Weiterhin wäre auch ein Einsatz eines selbst-stabilisierenden Synchronisationsverfahren, wie z.B. der so genannte Firefly Clock Synchronisations-Algorithmus oder von Auswahlalgorithmen (z.B. Leader Election-Verfahren) denkbar, bei welchen sich die Sensoreinheiten SE11, SE12, SE13, SE21, SE22, SE23, SE31, SE32, SE33, welche auf derselben Leitung L1, L2, L3 angebracht sind, untereinander bzw. dezentral synchronisieren.

Eine weitere Möglichkeit der Synchronisation der Sensoreinheiten SE11, SE12, SE13, SE21, SE22, SE23, SE31, SE32, SE33 bzw. Sensorgruppen G1, G2, G3 bietet beispielweise ein verteilter Ansatz, welcher auf der Idee von Buszugriffsverfahren, wie z.B. Carrier Sense Multiple Access oder kurz: CSMA, basiert. Dabei wird z.B. die Ladephase einer Sensoreinheit SE11, SE12, SE13, SE21, SE22, SE23, SE31, SE32, SE33 mit einer Sendephase bei einem Zugriff auf einen Datenbus verglichen, bei welcher es zu vermeiden gilt, dass in einem lokal begrenzten Gebiet beispielsweise zwei Sensoreinheiten SE11, SE12, SE13, SE21, SE22, SE23, SE31, SE32, SE33 zeitgleich laden bzw. aus dem Energieversorgungsnetz Strom entnehmen - vergleichbar mit einem Senden bei CSMA.

## Patentansprüche

1. Sensoreinheit zum Erkennen von Fehlerströmen in einem Energieversorgungsnetz, zumindest mit:
- einem Stromwandler (SW), welcher sowohl zum Ermitteln eines Stroms (I) in einem zu überwachenden Leiter (L) des Energieversorgungsnetzes in einer Messphase als auch zum Aufladen der Sensoreinheit (SE) in einer Ladephase eingesetzt wird;
- einem Lastwiderstand (Rb), über welchen in der Messphase der Strom (I) im zu überwachenden Leiter (L) ermittelbar ist;
- einem Energiebuffer (EB) für eine interne Energieversorgung der Sensoreinheit (SE), welcher über eine Ladeschaltung (HS) in der Ladephase aufgeladen wird;
- und einer elektronischen Einheit (MMT) zur Ansteuerung der Sensoreinheit und zum Auswerten und Übertragen von Messergebnissen;
wobei die elektronische Einheit (MMT) dazu eingerichtet ist, eine Ladespannung (LP) am Energiebuffer (EB) zu überwachen und mit einem oberen Schwellwert zu vergleichen; **dadurch gekennzeichnet, dass** die elektronische Einheit weiterhin dazu eingerichtet ist, die Ladespannung mit einem unteren Schwellwert zu vergleichen, und dass die Sensoreinheit (SE) zwei Schaltelemente (S1, S2) aufweist, welche durch die elektronische Einheit (MMT) derart angesteuert werden, dass bei Erreichen und/oder Überschreiten des oberen Schwellwerts durch die Ladespannung (LP) am Energiebuffer (EB) ein erstes Schaltelement (S1) geschlossen wird und ein zweites Schaltelement (S2) geöffnet wird, wodurch die Sensoreinheit (SE) in die Messphase versetzt wird, und dass bei Erreichen und/oder Unterschreiten des unteren Schwellwerts durch die Ladespannung (LP) am Energiebuffer (EB) das erste Schaltelement (S1) geöffnet wird und das zweite Schaltelement (S2) geschlossen wird, wodurch die Sensoreinheit (SE) in die Ladephase versetzt wird, wobei die elektronische Einheit dazu eingerichtet ist, während der Ladephase die Ladespannung (LP) am Energiebuffer (EB) für eine Ableitung des Strom (I) im zu überwachenden Leiter (L) heranzuziehen.

2. Sensoreinheit nach Anspruch 1, ***dadurch gekennzeichnet*, *dass*** der untere Schwellwert für die Ladespannung (LP) am Energiebuffer (EB) derart festgelegt ist, dass im Energiebuffer (EB) eine Energiemenge für einen reduzierten Betrieb der Sensoreinheit (SE) während der Ladephase verfügbar ist, und dass der obere Schwellwert für die Ladespannung (LP) am Energiebuffer (EB) derart festgelegt ist, dass der Energiebuffer (EB) für ein hochauflösendes Messen des Stroms (I) im zu überwachenden Leiter (L) und die Übertragung der Messergebnisse aufgeladen ist.

3. Sensoreinheit nach einem der vorangegangenen Ansprüche, ***dadurch gekennzeichnet, dass*** die elektronische Einheit (MMT) der Sensoreinheit (SE) zumindest aufweist:
- eine Ansteuerung (AN), durch welche die zwei Schaltelemente (S1, S2) mittels Ansteuersignalen gegengleich ansteuerbar sind;
- eine Messschaltung (MS) zum Verarbeiten und Auswerten von Messwerten (MW) und der Ladespannung (LP) am Energiebuffer (EB); und
- eine Funkmodul (FM) zum Übertragen von Messergebnissen, welche aus den Messwerten (MW) und der Ladespannung (LP) ableitbar sind.

4. Sensoreinheit nach Anspruch 3, ***dadurch gekennzeichnet*, *dass*** die Messschaltung (MS) dazu eingerichtet ist, während der Messphase aus Messwerten (MW) am Lastwiderstand (Rb) den Strom und/oder Fehlerströme (I) im zu überwachenden Leiter (L) des Energieversorgungsnetzen zu ermitteln, und während der Ladephase die Ladespannung (LP) am Energiebuffer (EB) zum Erkennen einer Höhe des Stroms (I) und/oder zum Erkennen von Fehlerströmen (I) im zu überwachenden Leiter (L) des Energieversorgungsnetzes zu verwenden.

5. Sensoreinheit nach einem der vorangegangenen Ansprüche, ***dadurch gekennzeichnet, dass*** die Sensoreinheit (SE) weiterhin eine Spannungsversorgungsschaltung (DC) aufweist, über welcher die elektronische Einheit (MMT) mit einer entsprechenden, stabilisierten Spannung aus dem Energiebuffer (EB) versorgt wird.

6. Sensoreinheit nach einem der vorangegangenen Ansprüche, ***dadurch gekennzeichnet, dass*** für eine drahtlose Übertragung der Messergebnisse der Sensoreinheit (SE) eine Funktechnologie mit niedrigem Energiebedarf und hoher Reichweite vorgesehen ist.

7. Sensoreinheit nach einem der vorangegangenen Ansprüche, ***dadurch gekennzeichnet, dass*** als erstes Schaltelement (S1) und als zweites Schaltelement (S2) der Sensoreinheit (SE) Transistoren, Feldeffekttransistoren oder Halbleiterschalter vorgesehen sind.

8. Sensoreinheit nach einem der vorangegangenen Ansprüche, ***dadurch gekennzeichnet, dass*** der Energiebuffer (EB) der Sensoreinheit (SE) als Kondensator, insbesondere als so genannter Superkondensator ausgeführt ist.

9. Verfahren zum Erkennen von Fehlerströmen in einem Energieversorgungsnetz mit einer Sensoreinheit (SE) nach den Ansprüche 1 bis 8, wobei während einer Messphase von der Sensoreinheit (SE) ein Strom (I) in einem zu überwachenden Leiter (L) des Energieversorgungsnetzes mit Hilfe eines Lastwiderstands (Rb) ermittelt wird, und wobei während einer Ladephase der Sensoreinheit (SE) ein Energiebuffer (EB) für die interne Energieversorgung der Sensoreinheit (SE) über eine Ladeschaltung (HS) aufgeladen wird, wobei eine Ladespannung (LP) am Energiebuffer (EB) der Sensoreinheit (SE) überwacht (101, 104) und mit einem oberen Schwellwert wird; **dadurch gekennzeichnet, dass** die Ladespannung weiterhin mit einem unteren Schwellwert verglichen wird (102, 105), dass bei Erreichen und/oder Überschreiten des oberen Schwellwerts durch die Ladespannung (LP) ein erstes Schaltelement (S1) der Sensoreinheit (SE) geschlossen und ein zweites Schaltelement (S2) der Sensoreinheit (SE) geöffnet wird (103), wodurch die Sensoreinheit in die Messphase versetzt wird, dass bei Erreichen und/oder Unterschreiten des unteren Schwellwerts durch die Ladespannung (LP) das erste Schaltelement (S1) geöffnet und das zweite Schaltelement (S2) geschlossen wird (106), wodurch die Sensoreinheit (SE) in die Ladephase versetzt wird, und dass während der Ladephase der Sensoreinheit (SE) die Ladespannung (LP) am Energiebuffer (EB) weiterhin gemessen wird (101) und zum Ableiten des Stroms (I) im zu überwachenden Leiter (L) des Energieversorgungsnetzes herangezogen wird.

10. Verfahren nach Anspruch 9, ***dadurch gekennzeichnet, dass*** der untere Schwellwert für die Ladespannung (LP) am Energiebuffer (EB) derart festgelegt wird, dass vom Energiebuffer (EB) der Sensoreinheit (SE) während der Ladephase eine Energiemenge zur Verfügung gestellt wird, mit welcher die Sensoreinheit (SE) während der Ladephase mit einer reduzierten Messfrequenz betrieben werden kann und Messergebnisse in einem reduzierten Umfang übertragen werden können.

11. Verfahren nach einem der Ansprüche 9 bis 10, ***dadurch gekennzeichnet, dass*** der obere Schwellwert für der Ladespannung (LP) am Energiebuffer (EB) derart festgelegt wird, dass der Energiebuffer (EB) mit einer Energiemenge geladen ist, mit welcher von der Sensoreinheit (SE) während der Messphase hochauflösend gemessen werden kann und Messergebnisse übertragen werden können.

12. Verfahren nach einem der Ansprüche 9 bis 11, ***dadurch gekennzeichnet, dass*** die Messergebnisse, welcher während der Messphase und während der Ladephase ermittelt werden (101, 104), von der Sensoreinheit (SE) drahtlos mittels einer Funktechnologie mit geringem Energieverbrauch und großer Reichweite an eine übergeordnete Kontrolleinheit übertragen werden.

13. Verfahren nach einem der Ansprüche 9 bis 12, ***dadurch gekennzeichnet, dass*** für eine Erkennung eines Fehlerstroms (I) während der Ladephase der Sensoreinheit (SE) ein Vergleich mit lokal und/oder zentral abgelegten, historischen Daten der Ladephase der Sensoreinheit (SE) durchgeführt wird (101).

14. Verfahren nach einem der Ansprüche 9 bis 13, ***dadurch gekennzeichnet, dass*** für eine Erkennung eines Fehlerstroms (I) in der Ladephase der Sensoreinheit (SE) ein Vergleich mit Messdaten von weiteren, im Energieversorgungsnetz angebrachten Sensoreinheiten (SE) durchgeführt wird (101).

15. Verfahren nach Anspruch 14, ***dadurch gekennzeichnet, dass*** für eine Übertragung der Messdaten der weiteren, im Energieversorgungsnetz angebrachten Sensoreinheiten (SE), welche für den Vergleich in der Ladephase herangezogen werden, eine Funktechnologie mit niedrigem Energiebedarf und geringer Reichweite verwendet wird.

## Claims

1. Sensor unit for identifying fault currents in a power supply network, at least having:
- a current transformer (SW) which is used to both determine a current (I) in a conductor (L), to be monitored, of the power supply network in a measuring phase and also to charge the sensor unit (SE) in a charging phase;
- a charging resistor (Rb), by way of which the current (I) in the conductor (L) to be monitored can be determined in the measuring phase;
- an energy buffer (EB) for an internal power supply of the sensor unit (SE), which is charged by way of a charging circuit (HS) in the charging phase;
- and an electronic unit (MMT) for controlling the sensor unit and for evaluating and transmitting measuring results;
wherein the electronic unit (MMT) is designed to monitor a charging voltage (LP) on the energy buffer (EB) and to compare the same with an upper threshold value; **characterised in that** the electronic unit is further designed to compare the charging voltage with a lower threshold value, and that the sensor unit (SE) has two switching elements (S1, S2) which are controlled by the electronic unit (MMT) in such a way that a first switching element (S1) is closed and a second switching element (S2) is opened when the upper threshold value is reached and/or exceeded by the charging voltage (LP) on the energy buffer (EB), as a result of which the sensor unit (SE) is moved into the measuring phase, and that the first switching element (S1) is opened and the second switching element (S2) is closed when the lower threshold value is reached and/or not met by the charging voltage (LP) on the energy buffer (EB), as a result of which the sensor unit (SE) is moved into the charging phase, wherein the electronic unit is designed to use the charging voltage (LP) on the energy buffer (EB) to derive the current in the conductor (L) to be monitored during the charging phase.

2. Sensor unit according to claim 1, ***characterised in that*** the lower threshold value is defined for the charging voltage (LP) on the energy buffer (EB) in such a way that in the energy buffer (EB) a quantity of energy is available for a reduced operation of the sensor unit (SE) during the charging phase, and that the upper threshold value is defined for the charging voltage (LP) on the energy buffer (EB) in such a way that the energy buffer (EB) is charged for a highly resolved measurement of the current (I) in the conductor (L) to be monitored and the transmission of the measuring results.

3. Sensor unit according to one of the preceding claims, ***characterised in that*** the electronic unit (MMT) of the sensor unit (SE) at least has:
- a control (AN), by means of which the two switching elements (S1, S2) can be controlled opposingly by means of control signals;
- a measuring circuit (MS) for processing and evaluating measured values (WM) and the charging voltage (LP) on the energy buffer (EB); and
- a radio module (FM) for transmitting measuring results, which can be derived from the measured values (MW) and the charging voltage (LP).

4. Sensor unit according to claim 3, ***characterised in that*** the measuring circuit (MS) is designed to determine the current and/or fault currents (I) in the conductor (L), to be monitored, of the power supply network during the measuring phase from measured values (WM) on the charging resistor (Rb) and to use the charging voltage (LP) on the energy buffer (EB) to identify a height of the current (I) and/or to identify fault currents (I) in the conductor (L), to be monitored, of the power supply network during the charging phase.

5. Sensor unit according to one of the preceding claims, ***characterised in that*** the sensor unit (SE) further has a voltage supply circuit (DC), by way of which the electronic unit (MMT) is supplied with a corresponding, stabilised voltage from the energy buffer (EB).

6. Sensor unit according to one of the preceding claims, ***characterised in that*** a radio technology with a low energy requirement and high range is provided for a wireless transmission of the measuring results of the sensor unit (SE).

7. Sensor unit according to one of the preceding claims, ***characterised in that*** transistors, field effect transistors or semiconductor switches are provided as a first switching element (S1) and as a second switching element (S2) of the sensor unit (SE).

8. Sensor unit according to one of the preceding claims, **characterised in that** the energy buffer (EB) of the sensor unit (SE) is designed as a capacitor, in particular as what is known as a supercapacitor.

9. Method for identifying fault currents in a power supply network with a sensor unit (SE) according to claims 1 to 8, wherein during a measuring phase a current (I) in a conductor (L), to be monitored, of the power supply network is determined by the sensor unit (SE) with the aid of a charging resistor (Rb), and wherein during a charging phase of the sensor unit (SE), an energy buffer (EB) is charged for the internal power supply of the sensor unit (SE) by way of a charging circuit (HS), wherein a charging voltage (LP) is monitored on the energy buffer (EB) of the sensor unit (SE) and is compared with an upper threshold value; **characterised in that** the charging voltage is further compared (102, 105) with a lower threshold value, that a first switching element (S1) of the sensor unit (SE) is closed and a second switching element (S2) of the sensor unit (SE) is opened (103) when the upper threshold value is reached and/or exceeded by the charging voltage (LP), as a result of which the sensor unit is moved into the measuring phase, that the first switching element (S1) is opened and the second switching element (S2) is closed when the lower threshold value is reached and/or not met by the charging voltage (LP), as a result of which the sensor unit (S2) is moved into the charging phase, and that during the charging phase of the sensor unit (SE) the charging voltage (LP) is measured on the energy buffer (EB) and is used to derive the current (I) in the conductor (L), to be monitored, of the power supply network.

10. Method according to claim 9, ***characterised in that*** the lower threshold value is defined for the charging voltage (LP) on the energy buffer (EB) in such a way that a quantity of energy is made available by the energy buffer (EB) to the sensor unit (SE) during the charging phase, with which quantity of energy the sensor unit (SE) can be operated during the charging phase with a reduced measuring frequency and measuring results can be transmitted to a reduced extent.

11. Method according to one of claims 9 to 10, ***characterised in that*** the upper threshold value for the charging voltage (LP) is defined on the energy buffer (EB) in such a way that the energy buffer (EB) is charged with a quantity of energy with which the sensor unit (SE) is able to be measured with high resolution during the measuring phase and measuring results can be transmitted.

12. Method according to one of claims 9 to 11, ***characterised in that*** the measuring results, which are determined (101, 104) during the measuring phase and during the charging phase, are wirelessly transmitted from the sensor unit (SE) to a higher-level control unit by means of a radio technology with a low energy consumption and a large range.

13. Method according to one of claims 9 to 12, ***characterised in that*** a comparison with locally and/or centrally stored, historical data of the charging phase of the sensor unit (SE) is carried out in order to recognise a fault current (I) during the charging phase of the sensor unit (SE).

14. Method according to one of claims 9 to 13, ***characterised in that*** a comparison with the measurement data of further sensor units (SE) attached in the power supply network is carried out (101) in order to identify a fault current (I) in the charging phase of the sensor unit (SE).

15. Method according to claim 14, ***characterised in that*** a radio technology with a low energy requirement and a small range is used for a transmission of the measurement data of the further sensor units (SE) attached in the power supply network, which are used for the comparison in the charging phase.

## Revendications

1. Unité de capteur permettant de détecter les courants de défaut dans un réseau d'alimentation en énergie, comprenant au moins :
- un transformateur de courant (SW), qui est utilisé à la fois pour déterminer un courant (I) dans un conducteur à surveiller (L) du réseau d'alimentation en énergie lors d'une phase de mesure et pour charger l'unité de capteur (SE) lors d'une phase de charge ;
- une résistance de charge (Rb), par l'intermédiaire de laquelle le courant (I) dans le conducteur à surveiller (L) peut être déterminé lors de la phase de mesure ;
- un accumulateur-tampon d'énergie (EB), chargé par l'intermédiaire d'un circuit de charge (HS) lors de la phase de charge et permettant une alimentation interne en énergie de l'unité de capteur (SE) ;
- et une unité électronique (MMT) permettant de commander l'unité de capteur et d'évaluer et de transmettre des résultats de mesure ;
dans laquelle l'unité électronique (MMT) est conçue afin de surveiller une tension de charge (LP) au niveau de l'accumulateur-tampon d'énergie (EB) et la comparer à une valeur de seuil supérieure ;
**caractérisée en ce que** l'unité électronique est en outre conçue afin de comparer la tension de charge à une valeur de seuil inférieure, et
**en ce que** l'unité de capteur (SE) comprend deux éléments de commutation (S1, S2) qui sont commandés par l'unité électronique (MMT) de telle manière que, lorsque la tension de charge (LP) au niveau de l'accumulateur-tampon d'énergie (EB) atteint et/ou dépasse la valeur de seuil supérieure, un premier élément de commutation (S1) est fermé et un deuxième élément de commutation (S2) est ouvert, ce qui place l'unité de capteur (SE) en phase de mesure, et de telle manière que, lorsque la tension de charge (LP) au niveau de l'accumulateur-tampon d'énergie (EB) atteint et/ou passe en dessous de la valeur de seuil inférieure, le premier élément de commutation (S1) est ouvert et le deuxième élément de commutation (S2) est fermé, ce qui place l'unité de capteur (SE) en phase de charge, l'unité électronique étant conçue afin de, pendant la phase de charge, utiliser la tension de charge (LP) au niveau de l'accumulateur-tampon d'énergie (EB) afin de dériver le courant (I) dans le conducteur à surveiller (L).

2. Unité de capteur selon la revendication 1, ***caractérisée en ce que*** la valeur de seuil inférieure pour la tension de charge (LP) au niveau de l'accumulateur-tampon d'énergie (EB) est fixée de telle manière qu'une quantité d'énergie pour un fonctionnement réduit de l'unité de capteur (SE) est disponible dans l'accumulateur-tampon d'énergie (EB) pendant la phase de charge, et **en ce que** la valeur de seuil supérieure pour la tension de charge (LP) au niveau de l'accumulateur-tampon d'énergie (EB) est fixée de telle manière que l'accumulateur-tampon d'énergie (EB) est chargé en vue d'une mesure à haute résolution du courant (I) dans le conducteur à surveiller (L) et de la transmission des résultats de mesure.

3. Unité de capteur selon l'une quelconque des revendications précédentes, ***caractérisée en ce que*** l'unité électronique (MMT) de l'unité de capteur (SE) présente au moins :
- une commande (AN), grâce à laquelle les deux éléments de commutation (S1, S2) peuvent être commandés en parallèle au moyen de signaux de commande ;
- un circuit de mesure (MS) permettant de traiter et d'évaluer des valeurs de mesure (MW) et la tension de charge (LP) au niveau de l'accumulateur-tampon d'énergie (EB) ; et
- un module radio (FM) permettant de transmettre des résultats de mesure qui peuvent être dérivés des valeurs de mesure (MW) et de la tension de charge (LP).

4. Unité de capteur selon la revendication 3, ***caractérisée en ce que* le** circuit de mesure (MS) est conçu afin de, pendant la phase de mesure, déterminer le courant et/ou les courants de défaut (I) dans le conducteur à surveiller (L) du réseau d'alimentation en énergie à partir de valeurs de mesure (MW) au niveau de la résistance de charge (Rb), et afin de, pendant la phase de charge, utiliser la tension de charge (LP) au niveau de l'accumulateur-tampon d'énergie (EB) afin de détecter une quantité du courant (I) et/ou afin de détecter des courants de défaut (I) dans le conducteur à surveiller (L) du réseau d'alimentation en énergie.

5. Unité de capteur selon l'une quelconque des revendications précédentes, ***caractérisée en ce que*** l'unité de capteur (SE) présente en outre un circuit d'alimentation en tension (DC), par l'intermédiaire duquel l'unité électronique (MMT) est alimentée en une tension stabilisée correspondante à partir de l'accumulateur-tampon d'énergie (EB).

6. Unité de capteur selon l'une quelconque des revendications précédentes, ***caractérisée en ce qu***'une technologie radio à faible consommation d'énergie et portée élevée est fournie en vue d'une transmission sans fil des résultats de mesure de l'unité de capteur (SE).

7. Unité de capteur selon l'une quelconque des revendications précédentes, ***caractérisée en ce que*** des transistors, des transistors à effet de champ ou des commutateurs à semiconducteurs sont fournis en tant que premier élément de commutation (S1) et en tant que deuxième élément de commutation (S2) de l'unité de capteur (SE).

8. Unité de capteur selon l'une quelconque des revendications précédentes, ***caractérisée en ce que*** l'accumulateur-tampon d'énergie (EB) de l'unité de capteur (SE) est réalisé sous la forme d'un condensateur, en particulier sous la forme de ce que l'on appelle un supercondensateur.

9. Procédé de détection de courants de défaut dans un réseau d'alimentation en énergie avec une unité de capteur (SE) selon les revendications 1 à 8, dans lequel, pendant une phase de mesure de l'unité de capteur (SE), un courant (I) est déterminé dans un conducteur à surveiller (L) du réseau d'alimentation en énergie à l'aide d'une résistance de charge (Rb), et dans lequel, pendant une phase de charge de l'unité de capteur (SE), un accumulateur-tampon d'énergie (EB) destiné à l'alimentation interne en énergie de l'unité de capteur (SE) est chargé par l'intermédiaire d'un circuit de charge (HS), dans lequel une tension de charge (LP) au niveau de l'accumulateur-tampon d'énergie (EB) de l'unité de capteur (SE) est surveillée (101, 104) et est comparée à une valeur de seuil supérieure ; **caractérisé en ce que** la tension de charge est en outre comparée à une valeur de seuil inférieure (102, 105), **en ce que**, lorsque la tension de charge (LP) atteint et/ou dépasse la valeur de seuil supérieure, un premier élément de commutation (S1) de l'unité de capteur (SE) est fermé et un deuxième élément de commutation (S2) de l'unité de capteur (SE) est ouvert (103), ce qui place l'unité de capteur en phase de mesure, **en ce que**, lorsque la tension de charge (LP) atteint et/ou passe en dessous de la valeur de seuil inférieure, le premier élément de commutation (S1) est ouvert et le deuxième élément de commutation (S2) est fermé (106), ce qui place l'unité de capteur (SE) en phase de charge, et **en ce que**, pendant la phase de charge de l'unité de capteur (SE), la tension de charge (LP) au niveau de l'accumulateur-tampon d'énergie (EB) est en outre mesurée (101) et est utilisée afin de dériver le courant (I) dans le conducteur à surveiller (L) du réseau d'alimentation en énergie.

10. Procédé selon la revendication 9, ***caractérisé en ce que*** la valeur de seuil inférieure pour la tension de charge (LP) au niveau de l'accumulateur-tampon d'énergie (EB) est fixée de telle manière qu'une quantité d'énergie, avec laquelle l'unité de capteur (SE) peut fonctionner avec une fréquence de mesure réduite pendant la phase de charge et avec laquelle des résultats de mesure peuvent être transmis dans une proportion réduite, est mise à disposition par l'accumulateur-tampon d'énergie (EB) de l'unité de capteur (SE) pendant la phase de charge.

11. Procédé selon l'une quelconque des revendications 9 à 10, ***caractérisé en ce que*** la valeur de seuil supérieure pour la tension de charge (LP) au niveau de l'accumulateur-tampon d'énergie (EB) est fixée de telle manière que l'accumulateur-tampon d'énergie (EB) est chargé avec une quantité d'énergie avec laquelle l'unité de capteur (SE) peut réaliser des mesures à haute résolution pendant la phase de mesure et des résultats de mesure peuvent être transmis.

12. Procédé selon l'une quelconque des revendications 9 à 11, ***caractérisé en ce que*** les résultats de mesure qui sont déterminés (101, 104) pendant la phase de mesure et pendant la phase de charge sont transmis sans fil par l'unité de capteur (SE) à une unité de contrôle supérieure au moyen d'une technologie radio à faible consommation d'énergie et portée élevée.

13. Procédé selon l'une quelconque des revendications 9 à 12, ***caractérisé en ce qu'***une comparaison avec des données historiques, stockées de manière locale et/ou centrale, de la phase de charge de l'unité de capteur (SE) est mise en oeuvre (101) en vue d'une détection d'un courant de défaut (I) pendant la phase de charge de l'unité de capteur (SE).

14. Procédé selon l'une quelconque des revendications 9 à 13, ***caractérisé en ce qu'***une comparaison avec des données de mesure d'unités de capteur (SE) supplémentaires installées dans le réseau d'alimentation en énergie est mise en oeuvre (101) en vue d'une détection d'un courant de défaut (I) lors de la phase de charge de l'unité de capteur (SE).

15. Procédé selon la revendication 14, ***caractérisé en ce qu***'une technologie radio à faible consommation d'énergie et faible portée est utilisée en vue d'une transmission des données de mesure des unités de capteur (SE) supplémentaires installées dans le réseau d'alimentation en énergie et utilisées pour la comparaison lors de la phase de charge.
